# EUROPEAN PATENT APPLICATION

(11) **EP 4 383 042 A1**
(43) Date of publication of application: **12.06.2024**
(21) Application number: 22212654.2
(22) Date of filing: 09.12.2022
(51) Int. Cl.: G06F 1/04, H03M 7/30

(54) **METHOD OF PROCESSING A TIMESTAMP, METHOD OF PROVIDING A TIMESTAMP AND CORRESPONDING ELECTRONIC SYSTEMS**

(71) Applicant: Valeo Comfort and Driving Assistance, 94000 Créteil (FR)
(72) Inventor: LEJAY, Frédéric, 94000 Créteil (FR); HERNANDEZ, Fabien, 94000 Créteil (FR); ABDELGAWAD, Mohamed, 94000 Créteil (FR)
(74) Representative: Delplanque, Arnaud

(57) **Abstract**

A method of processing a first timestamp (T1) defined on a first number of bits and representing a first number of seconds elapsed at a given date and time since a first epoch, comprises a step (S4) of converting said first timestamp (T1) into a second timestamp (T2) defined on a second number of bits and representing a second number of seconds elapsed at said given date and time since a second epoch; the second epoch is after the first epoch.

A method of providing a timestamp and correspond electronic systems are also described.

## Description

### TECHNICAL FIELD OF THE INVENTION

The invention relates to the technical field of information technology.

More precisely the invention relates to a method of processing a timestamp, a method of providing a timestamp and corresponding electronic systems.

### BACKGROUND INFORMATION AND PRIOR ART

In computer systems, a particular date and time is often represented by an integer, stored as a byte (or word) having a fixed, predefined number of bits, and indicating the number of seconds elapsed since a fixed, predefined date and time, called an epoch. Such an integer is generally called a timestamp.

For instance, Unix time is represented by a signed integer indicating the number of seconds elapsed since January 1^{st}, 1970 at 00:00 UTC (known as the Unix epoch).

The word length *(i.e.* bit length) of timestamps conventionally corresponds to the basic word length of words (or bytes) used by the system concerned.

For instance, 32-bit timestamps are conventionally used on 32-bit platforms.

The dates and times possibly represented by such timestamps is thus limited in time, for instance up to January 19, 2038 at 03:14:07 UTC for time representations using a signed integer on 32 bits and the Unix epoch.

To avoid this issue, it has been proposed to extend the number of bits of timestamps. 64-bit signed integers used as timestamps will remain valid for more than 292 billion years.

### SUMMARY OF THE INVENTION

In this context, the invention provides a method of processing a first timestamp defined on a first number of bits and representing a first number of seconds elapsed at a given date and time since a first epoch, comprising a step of converting said first timestamp into a second timestamp defined on a second number of bits and representing a second number of seconds elapsed at said given date and time since a second epoch, wherein the second epoch is after the first epoch.

Thanks to this conversion, the second timestamp may represent the same date and time using a reduced number of seconds *("second number of seconds")* and may thus be defined on a smaller number of bits (*"second number of bits"*). This makes it possible to keep storing timestamps using this (smaller) number of bits even for dates and times which would have needed an increased number of bits for their representation according to the standard manner *(i.e.* counting seconds elapsed since a standard epoch such as the Unix epoch).

The method may then comprise a step of storing the second timestamp in a memory.

In a first situation, the method can comprise a preliminary step of reading the first timestamp in said memory. Storing the second timestamp in memory may in this case be used to update the first timestamp initially stored in memory.

In another situation, the method can comprise a preliminary step of receiving the first timestamp through an interface. This is the case in particular the first timestamp (for instance a standardized timestamp) is received (through the interface) by an external electronic device. The date and time represented (in a standardized manner) by the first timestamp may thus be represented by the second timestamp internally to the electronic system implementing the method and/or including the memory.

The invention also propose a method of providing a first timestamp defined on a first number of bits and representing a first number of seconds elapsed at a given date and time since a first epoch, wherein said method comprises a step of converting a second timestamp defined on a second number of bits and representing a second number of seconds elapsed at said given date and time since a second epoch into said first timestamp, wherein the second epoch is after the first epoch.

This makes it possible for instance to obtain a standardized timestamp (*"first timestamp"*) from a second timestamp defined based on a more recent epoch and thus possibly on a reduced number of bits, this second timestamp being used internally within the electronic system, as explained above.

The method may comprise a preliminary step of reading the second timestamp in a memory.

As the first timestamp may correspond to a standardized timestamp, it may in this case be used outside of the electronic system; the method may thus comprise a step of sending the first timestamp through an interface.

The first number of bits may be greater than the second number of bits, in particular when the first timestamp is received or sent through the interface. As explained above, increasing the number of bits of the timestamp is a conventional solution to avoid the issue presented in introduction and timestamps defined on the first number of bits (greater than the second number of bits) are to be used outside of the electronic system.

In practice, the second epoch may be a fixed number of years later than the first epoch.

The step of converting is for instance performed by a processor including a data bus having a width equal to said second number of bits (or a processor including at least one register which size is equal to said second number of bits). In this case, the converting step proposed above makes it possible to keep using timestamps defined on this second number of bits within the electronic system including the processor.

In a possible embodiment, the first number of bits is equal to 64 and/or the second number of bits is equal to 32.

When such methods are implemented in an electronic system including a processor, at least some of the steps described above may be executed by the processor (possibly due to execution by the processor of instructions stored in a memory of the electronic system).

The invention also provides an electronic system including a processor and a memory, wherein the memory stores instructions executable by the processor and adapted to perform the following step when executed by the processor:
converting a first timestamp defined on a first number of bits and representing a first number of seconds elapsed at a given date and time since a first epoch into a second timestamp defined on a second number of bits and representing a second number of seconds elapsed at said given date and time since a second epoch, wherein the second epoch is after the first epoch.

The processor may be configured or programmed to store the second timestamp in the memory (or in another memory of the electronic system).

The electronic system may further comprise an interface; the processor may then be configured or programmed to receive the first timestamp through the interface.

The invention also provides an electronic system including a processor and a memory, wherein the memory stores instructions executable by the processor and adapted to perform the following step when executed by the processor:
converting a second timestamp defined on a second number of bits and representing a second number of seconds elapsed at a given date and time since a second epoch into a first timestamp defined on a first number of bits and representing a first number of seconds elapsed at said given date and time since a first epoch, wherein the second epoch is after the first epoch.

The processor may be configured or programmed to read the second timestamp in the memory (or in another memory of the electronic system).

The electronic system may further comprise an interface; the processor may then be configured or programmed to send the first timestamp through the interface.

Other options presented hereabove in connection with the proposed methods may also apply to these electronic systems.

The invention also proposes a computer program comprising instructions executable by a processor and designed such that the processor performs any of the methods described above when these instructions are executed by the processor.

Other features and advantages of the embodiments of the present invention will be better understood upon reading of preferred embodiments thereof with reference to the appended drawings.

### BRIEF DESCRIPTION OF THE DRAWINGS

Figure 1 shows the main elements of an electronic system;
Figure 2 is a flowchart showing the main steps of a first exemplary method;
Figure 3 is a flowchart showing the main steps of a second exemplary method;
Figure 4 is a flowchart showing the main step of a first method for updating timestamps; and
Figure 5 is a flowchart showing the main step of a second method for updating timestamps.

### DETAILED DESCRIPTION OF EXAMPLE(S)

As will be apparent from the example described below, in order to reduce the necessary changes in an electronic system (e.g. a computer system), it is proposed here that this electronic system uses internally a more recent epoch than the epoch conventionally used (e.g. the Unix epoch), with the result that smaller integers are used as timestamps indicating the number of seconds elapsed since this more recent epoch when representing current dates and times, such that the number of bits used for timestamps needs not be increased.

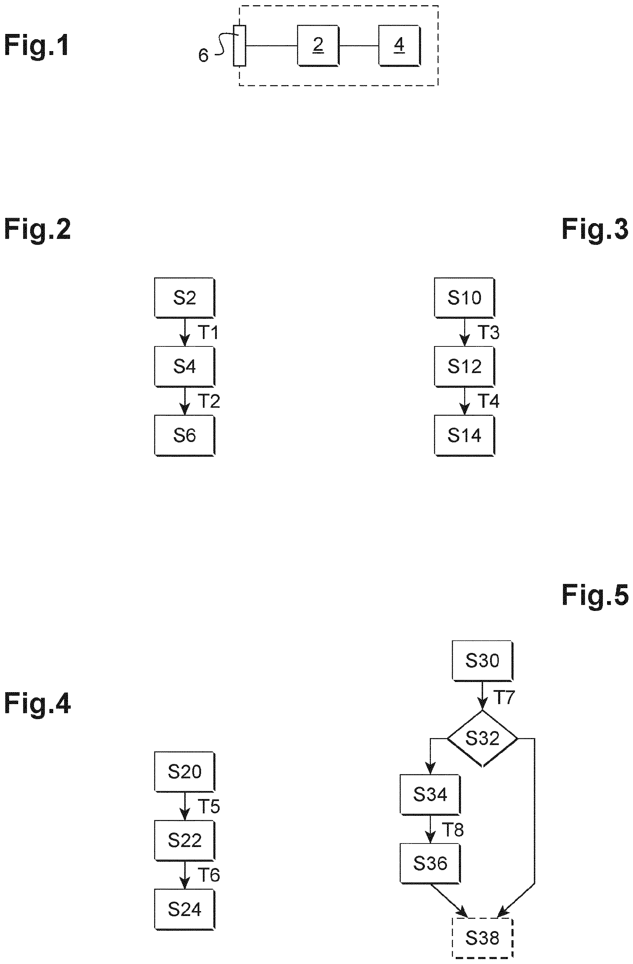

Figure 1 shows the main elements of an electronic system in which the invention may be implemented.

This electronic system is for instance an electronic control unit, such as used in automotive vehicles.

The electronic system of Figure 1 includes a processor 2, a memory 4 and an input-output (I/O) interface 6.

The processor 2 is for instance a microprocessor. The processor 2 includes a data bus (*e.g.* to exchange data with memory 4) having a width equal to Np bits and/or internal registers of size Np bits. For instance, if the electronic system is a 32-bit platform, Np = 32.

The memory 4 is here a non-volatile rewritable memory, such as an Electrically Erasable & Programmable Memory (EEPROM).

Memory 4 stores computer program instructions that are executable by processor 2 and designed such that processor 2 implements at least one of the methods described below when these instructions are executed by processor 2.

Memory 4 also stores pieces of data used during operation of the electronic system and timestamps respectively associated with these pieces of data (for instance in a file system).

Timestamps stored in memory 4 (or in another memory of the electronic system, such as a random access memory, for instance) have a fixed bit-length, denoted Ni in the following. The bit-length Ni of timestamps *(i.e.* the number of bits used for timestamps) is here equal to the size of internal registers or the width of data buses in the electronic system, denoted Np as explained above. In the present example, Ni = 32.

Timestamps stored in memory 5 (or in any other memory of the electronic system) each have an integer value equal to the number of seconds elapsed since an internal epoch at the date and time represented by the timestamp concerned.

As explained above, this internal epoch is more recent *(i.e.* later) than a standardized epoch to be used when exchanging timestamps with external devices.

In the present example, the standardised epoch is the Unix epoch *(i.e.* January 1^{st}, 1970 at 00:00) whereas the internal epoch is January 1^{st}, 1990 at 00:00).

The internal epoch may be a fixed number of years (here 20 years) later than the standardised epoch. This fixed number of years may be larger than 10 years and/or smaller than 40 years.

The I/O interface 6 makes it possible to connect the electronic system (and specifically the processor 2) to at least an external electronic device, for instance via a data network coupled to the I/O interface 6, and therefore to exchange data between the processor 2 and the external electronic device.

Data (including timestamps), e.g. a piece of data with an associated timestamp, can thus be sent (from the processor 2 and/or to the external electronic device) through the I/O interface 6 and/or received (from the external electronic device and/or by the processor 2) through the I/O interface 6.

Figure 2 is a flowchart of a first exemplary method usable in the frame of the invention.

This method starts with a step S2 during which the processor 2 receives a piece of data and an associated timestamp T1 (denoted *"external timestamp T1"* in the following) through the I/O interface 6.

This external timestamp T1 is an integer equal to the number of seconds elapsed since the standardised epoch at the date and time represented by this external timestamp T1. The external timestamp T1 is a byte having a bit-length Ne which is here larger than the bit-length Ni of timestamps stored in memory 4 (or in any other memory of the electronic device). In the present example, Ne = 64.

The method of Figure 2 then includes a step S4 of converting the external timestamp T1 into a timestamp T2 (hereinafter referred to as *"internal timestamp T2"*) whose bit-length is equal to Ni and which is an integer equal to the number of seconds elapsed since the internal epoch at the date and time represented by the external timestamp T1.

This conversion is for instance performed by subtracting, from the external timestamp T1, the number of seconds elapsed from the standardised epoch to the internal epoch *(i.e.* here the number of seconds elapsed during the fixed number of years separating the standardised epoch and the internal epoch).

In the present example, the internal epoch is 20 years later than the standardized epoch and the conversion is thus performed by subtracting 631,152,000 from the external timestamp T1.

Said differently, T2 = T1 - 631,152,000 (and the internal timestamp T2 is represented on Ni bits).

The method of Figure 2 then includes a step S6 of storing the received piece of data in association with the internal timestamp T2 in memory 4 (or, in alternative embodiments, in another memory of the electronic system, such as a random access memory).

The internal timestamp T2 may thus be stored in a memory space having a bit-length equal to Ni (here 32 bits). A memory space having a bit-length equal to Ne (here 64 bits) is therefore not needed. In addition, for legacy electronic systems designed using 32-bit timestamps, there is no need to redefine memory allocation even though 64-bit timestamps are used in exchanges with external electronic devices.

Figure 3 is a flowchart of a second exemplary method usable in the frame of the invention.

This method starts with a step S10 during which a piece of data and an associated timestamp T3 are read from memory 4 (or, as a possible variation, in another memory of the electronic system, such as a random access memory).

Timestamp T3 is referred to as an internal timestamp in the following.

As explained above, internal timestamp T3, as a timestamp stored in a memory of the electronic system, is an integer equal to the number of seconds elapsed since the internal epoch at the date and time represented by internal timestamp T3.

The method of Figure 3 continues with a step S12 of converting the internal timestamp T3 into a timestamp T4 (hereinafter: *"external timestamp T4")* whose bit-length is equal to Ne and which is an integer equal to the number of seconds elapsed since the standardised epoch at the date and time represented by internal timestamp T3.

This conversion is for instance performed by adding, to the internal timestamp T3, the number of seconds elapsed from the standardised epoch to the internal epoch *(i.e.* here the number of seconds elapsed during the fixed number of years separating the standardised epoch and the internal epoch).

In the present example, the internal epoch is 20 years later than the standardized epoch and the conversion is thus performed by adding 631,152,000 to the internal timestamp T3.

Said differently, T4 = T3 + 631,152,000 (and the external timestamp T4 is represented on Ne bits).

The method of Figure 3 then includes a step S14 of sending the piece of data and the external timestamp T4 to an external electronic device through the I/O interface 4.

Thus, although the internal timestamp T3 is stored on Ni bits (e.g. using a legacy file system), an external timestamp T4 representing the same date and time in a standardised manner is send out of the electronic system to be used in the external electronic device.

In the examples just described, the timestamp is received, read, stored or sent in association with a piece of data. However, in other embodiments, the timestamp may be processed *(i.e.* received, read, stored or sent) in isolation *(e.g.* when the timestamp itself corresponds to the data processed by the processor 2).

Figure 4 is a flow chart of a first method for updating timestamps before using the method of Figure 2 or the method of Figure 3.

This method may be applied in an electronic system in which timestamps initially stored represent date and time in the standardised manner, *i.e.* as an integer equal to the number of seconds elapsed since the standardised epoch. In the present example, these (legacy) timestamps are defined on Ni bits.

The following steps are applied to each and every timestamp stored in the memory 4 (and possibly in other memories of the electronic device).

The method of Figure 4 starts with a step S20 of reading a timestamp T5 (hereinafter referred to as *"standard timestamp T5")* at a given location in memory 4 (or in another memory of the electronic device, such as a random access memory).

This given location may be the location of a timestamp associated with a piece of data, e.g. in a file system.

Timestamp T5 is an integer equal to the number of seconds elapsed since the standard epoch at a given date and time (thus represented in a standardised manner by timestamp T5).

The method then includes a step S22 of converting the timestamp T5 into a timestamp T6 (hereinafter *"internal timestamp T6"*) whose bit-length is Ni and which is equal to the number of seconds elapsed since the internal epoch at the date and time represented (in a standardised manner) by the standard timestamp T5.

This step S22 can be performed in the same way as step S4 described above and is thus not further described here.

The method of Figure 4 then includes a step S24 of storing the internal timestamp T6 at said given location (in the memory 4 or another memory of this electronic device), thus replacing the standard timestamp T5.

Once this method is implemented for all timestamps stored in memory 4 (and possibly in any other memory of the electronic device), standard timestamps are replaced with internal timestamps (such as used in the electronic system of Figure 1 as described above), such that the electronic device can implement the method of Figure 2 or the method of Figure 3.

Figure 5 is a flow chart of a second method for updating timestamps.

Like the method of Figure 4, this method may be applied in an electronic system in which timestamps initially stored represent date and time in the standardised manner, *i.e.* as an integer equal to the number of seconds elapsed since the standardised epoch. In the present example, these (legacy) timestamps are defined on Ni bits.

Unlike the method of Figure 4 however, this method is not systematically applied to each and every timestamp at a time, but only upon using a specific timestamp, as now explained.

The method of Figure 5 starts with a step S30 of reading a timestamp T7 at a given location in memory 4 (or in another memory of the electronic device, such as a random access memory).

This given location may be the location of a timestamp associated with a piece of data, e.g. in a file system.

The method of Figure 5 then includes a step S32 of determining whether the value of the timestamp T7 *(i.e.* the integer forming the timestamp T7) is above a predetermined threshold value or not.

This threshold value corresponds for instance to the number of seconds elapsed during 40 years, *i.e.* 1,262,304,000.

If the timestamp T7 is above the predetermined threshold value, it is considered here that the timestamp T7 represents date and time in the standardised manner, *i.e.* by the number of seconds elapsed since the standard epoch, and the method then continues in step S34 now described.

In step S34, timestamp T7 is converted into a timestamp T8 (hereinafter *"internal timestamp T8')* whose bit-length is Ni and which is equal to the number of seconds elapsed since the internal epoch at the date and time represented by the timestamp T7 (considered as standard timestamp).

This step S34 can be performed in the same way as step S4 described above and is thus not further described here.

The method of Figure 5 then includes a step S36 of storing the internal timestamp T8 at said given location (in the memory 4 or another memory of this electronic device), thus replacing the timestamp T7.

The timestamp stored in the given location can then be used as an internal timestamp within the electronic system (step S38), counting seconds elapsed since the internal epoch, as explained above (in particular with reference to Figure 3).

If step S32 determines that the timestamp T7 is not above the predetermined threshold value, it is considered here that the timestamp T7 has already been converted into an internal timestamp (by a prior application of steps S34 and S36) and the method directly thus jumps in this case to step S38, where the timestamp stored at the given location (timestamp T7 in this case) can be used as an internal threshold.

The method of Figure 5 makes it possible to update timestamps from standard timestamps to internal timestamps smoothly, when the concerned timestamp is used by the electronic system. This method is applicable to electronic systems in which it is known that all stored timestamps are accessed within a fixed period of time (in order to make sure that the determination of step S32 correctly separates standard timestamps and already updated, internal timestamps).

## Claims

1. A method of processing a first timestamp (T1; T5; T7) defined on a first number of bits and representing a first number of seconds elapsed at a given date and time since a first epoch, comprising a step (S4; S22; S34) of converting said first timestamp (T1; T5; T7) into a second timestamp (T2; T6; T8) defined on a second number of bits and representing a second number of seconds elapsed at said given date and time since a second epoch, wherein the second epoch is after the first epoch.

2. A method according to claim 1, comprising a step (S6; S24; S36) of storing the second timestamp (T2; T6; T8) in a memory (4).

3. A method according to claim 2, comprising a preliminary step (S20; S30) of reading the first timestamp (T5; T7) in said memory (4).

4. A method according to claim 1 or 2, comprising a preliminary step (S2) of receiving the first timestamp (T1) through an interface (6).

5. A method of providing a first timestamp (T4) defined on a first number of bits and representing a first number of seconds elapsed at a given date and time since a first epoch, wherein said method comprises a step (S12) of converting a second timestamp (T3) defined on a second number of bits and representing a second number of seconds elapsed at said given date and time since a second epoch into said first timestamp (T4), wherein the second epoch is after the first epoch.

6. A method according to claim 5, comprising a preliminary step (S10) of reading the second timestamp (T3) in a memory (4).

7. A method according to claim 4 or 5, comprising a step (S14) of sending the first timestamp (T4) through an interface (6).

8. A method according to any of claims 1-7, wherein the second epoch is a fixed number of years later than the first epoch.

9. A method according to any of claims 1-8, wherein the step of converting is performed by a processor (2) including a data bus having a width equal to said second number of bits.

10. A method according to any of claims 1-9, wherein the first number of bits is equal to 64 and wherein the second number of bits is equal to 32.

11. An electronic system including a processor (2) and a memory (4), wherein the memory (4) stores instructions executable by the processor (2) and adapted to perform the following step when executed by the processor (2):
converting a first timestamp (T1; T5; T7) defined on a first number of bits and representing a first number of seconds elapsed at a given date and time since a first epoch into a second timestamp (T2; T6; T8) defined on a second number of bits and representing a second number of seconds elapsed at said given date and time since a second epoch, wherein the second epoch is after the first epoch.

12. An electronic system according to claim 11, wherein the processor (2) is configured or programmed to store the second timestamp (T2; T6; T8) in the memory (4).

13. An electronic system according to claim 11 or 12, further comprising an interface (6), wherein the processor (2) is configured or programmed to receive the first timestamp (T1) through the interface (6).

14. An electronic system including a processor (2) and a memory (4), wherein the memory (4) stores instructions executable by the processor (2) and adapted to perform the following step when executed by the processor (2):
converting a second timestamp (T3) defined on a second number of bits and representing a second number of seconds elapsed at a given date and time since a second epoch into a first timestamp (T4) defined on a first number of bits and representing a first number of seconds elapsed at said given date and time since a first epoch, wherein the second epoch is after the first epoch.

15. An electronic system according to claim 14, wherein the processor (2) is configured or programmed to read the second timestamp (T3) in the memory.
